Europäisches Patentamt

European Patent Office

Office européen des brevets

(19)

(11) EP 0 901 664 B1

(12) EUROPÄISCHE PATENTSCHRIFT

(45) Veröffentlichungstag und Bekanntmachung des Hinweises auf die Patenterteilung:
05.09.2001 Patentblatt 2001/36

(51) Int Cl.⁷: G06K 7/08, G06K 7/10, H03J 7/02

(21) Anmeldenummer: 97925838.1

(22) Anmeldetag: 05.05.1997

(86) Internationale Anmeldenummer:
PCT/DE97/00913

(87) Internationale Veröffentlichungsnummer:
WO 97/45807 (04.12.1997 Gazette 1997/52)

(54) **VORRICHTUNG UND VERFAHREN ZUM KONTAKTLOSEN ÜBERTRAGEN VON ENERGIE ODER DATEN**

METHOD AND DEVICE FOR THE CONTACTLESS TRANSMISSION OF ENERGY OR DATA

PROCEDE ET DISPOSITIF DE TRANSMISSION SANS CONTACT D'ENERGIE OU DE DONNEES

(84) Benannte Vertragsstaaten:
DE FR GB

(30) Priorität: 24.05.1996 DE 19621076

(43) Veröffentlichungstag der Anmeldung:
17.03.1999 Patentblatt 1999/11

(73) Patentinhaber: SIEMENS AKTIENGESELLSCHAFT
80333 München (DE)

(72) Erfinder: ZIMMER, Herbert
D-93049 Regensburg (DE)

(56) Entgegenhaltungen:
EP-A- 0 676 860          DE-A- 4 332 798
DE-A- 19 518 106         US-A- 5 111 186

**Beschreibung**

Die Erfindung betrifft eine Vorrichtung und ein Verfahren zum kontaktlosen Übertragen von Energie oder Daten, insbesondere eine Diebstahlschutzvorrichtung für ein Kraftfahrzeug, bei der Energie oder Daten zwischen einer stationären Einheit im Kraftfahrzeug und einem tragbaren Transponder ausgetauscht werden.

Derartige Vorrichtungen bestehen zumeist aus einer stationären Einheit und einer tragbaren Einheit (Transponder), die zum Beispiel auf einer Chipkarte oder einem Schlüssel angeordnet ist. Die stationäre Einheit übermittelt hierbei Energie an den Transponder, wodurch Daten von dem Transponder zurückgesendet werden. Hierzu ist vorwiegend ein induktiv (transformatorisch) gekoppeltes Spulenpaar vorgesehen, wobei jede Spule je einem Schwingkreis in der stationären Einheit und in dem Transponder zugeordnet ist. Die Daten- und Energieübertragung erfolgt dabei durch ein hochfrequentes Magnetfeld, durch das in dem jeweils anderen Schwingkreis eine Schwingung angeregt wird.

Sowohl die stationäre Einheit als auch der Transponder können dabei Daten oder Energie sowohl senden als auch empfangen.

Bei derartigen Vorrichtungen zum kontaktlosen Übertragen von Energie oder Daten ist der Wirkungsgrad bekanntermaßen am höchsten, wenn die den Schwingkreis erregende Erregerfrequenz in etwa mit der Resonanzfrequenz des Schwingkreises übereinstimmt. Aufgrund von Bauelementetoleranzen und Temperatureinflüssen kann sich jedoch die Resonanzfrequenz eines Schwingkreises verschieben. Es ist daher ein Abgleich des Schwingkreises, d.h. der Resonanzfrequenz, notwendig.

Bei einer bekannten Vorrichtung zum kontaktlosen Übertragen von Energie oder Daten (DE 38 10 702 C2) geschieht dieser Abgleich eines Schwingkreises durch einen Regelkreis, durch den Kapazitätsdioden dem Schwingkreis hinzugeschaltet werden. Je nach Regelspannung ändert sich die Kapazität der Kapazitätsdioden, wodurch sich die Gesamtkapazität des Schwingkreises und damit die Resonanzfrequenz ändert. Mit einer solchen Vorrichtung ist eine kontinuierliche Veränderung der Resonanzfrequenz möglich.

Allerdings ist mit einer solchen Vorrichtung nur eine kapazitive Änderung der Schwingkreiseigenschaften möglich. Da überdies die Sperrschicht bei Kapazitätsdioden die Funktion eines Kondensators übernimmt, ist mit einer solchen Vorrichtung nur eine geringe Änderung der Kapazitätswerte möglich. Außerdem weisen Kapazitätsdioden große Bauelementetoleranzen auf. Durch Temperatureinfluß ändert sich ihr Sperrverhalten und somit ihre Kapazität, wodurch das Einsatzgebiet solcher Kapazitätsdioden sehr beschränkt ist.

Bei einer weiteren bekannten Vorrichtung (DE 44 38 287 C1) werden mehrere Kondensatoren parallel zu dem Schwingkreis geschaltet, um die Resonanzfrequenz an die Erregerfrequenz anzupassen. Mit einer solchen Vorrichtung ist jedoch keine kontinuierliche, sondern nur eine stufenweise Anpassung des Schwingkreises möglich.

Das Problem der vorliegenden Erfindung ist es, eine Vorrichtung und ein Verfahren zum kontaktlosen Übertragen von Daten oder Energie zu schaffen, bei dem die Resonanzfrequenz eines Sende-/Empfangsschwingkreises kontinuierlich und in einem weiten Bereich geändert werden kann.

Dieses Problem wird erfindungsgemäß durch die Merkmale der Patentansprüche 1 und 4 gelöst. Vorteilhafte Ausgestaltungen der Erfindung sind in den Unteransprüchen gekennzeichnet.

Mit der vorliegenden Erfindung kann die Resonanzfrequenz eines Schwingkreises auf einfache Weise kontinuierlich verändert werden. Der Schwingkreis kann dabei sowohl kapazitiv als auch induktiv durch eine nur phasenweise zuschaltbare Impedanz verändert werden. Als Impedanzen können Kapazitäten oder Induktivitäten verwendet werden, deren Grundwerte infolge von Temperatureinflüssen gegenüber Halbleiterbauelementen nur gering variieren. Außerdem sind solche Impedanzen nur mit geringen Bauelementetoleranzen behaftet.

Ausführungsbeispiele der Erfindung werden im folgenden anhand der in der Zeichnung dargestellten schematischen Figuren näher erläutert. Es zeigen:

| | |
|---|---|
| Figur 1: | ein Blockschaltbild einer erfindungsgemäßen Vorrichtung, |
| Figur 2a bis 2d: | Ausführungsbeispiele der Vorrichtung nach Figur 1, |
| Figur 3: | eine Schaltungsanordnung (Ersatzschaltbild) zum Verändern der Resonanzfrequenz eines Schwingkreises und |
| Figur 4a bis 4h: | Signaldiagramme der Schaltungsanordnung nach Figur 3. |

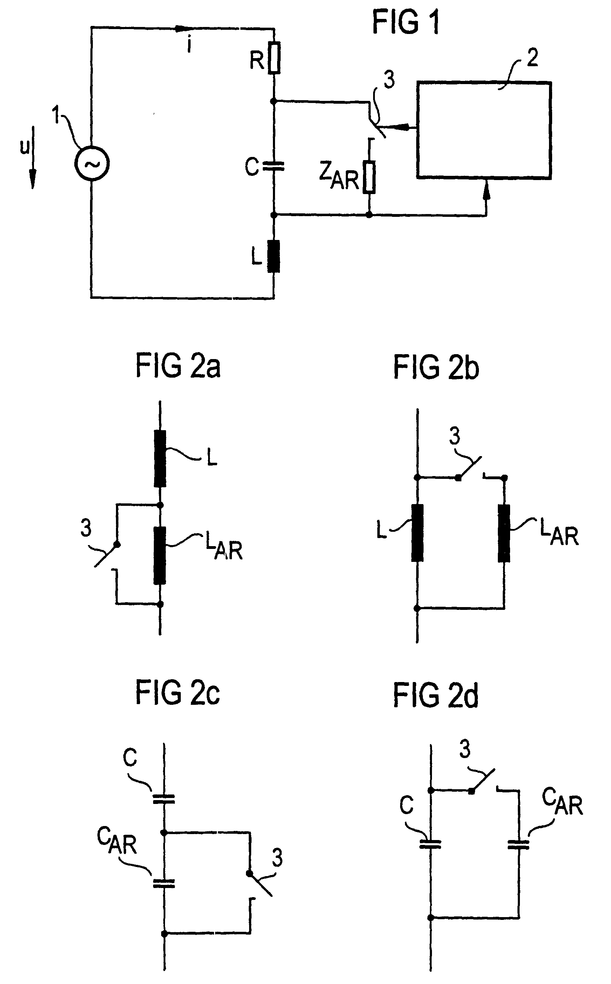

Eine erfindungsgemäße Vorrichtung zum kontaktlosen Übertragen von Energie oder Daten weist einen LC-Schwingkreis (Figur 1) auf (Reihenschwingkreis oder Parallelschwingkreis), der aus einem Widerstand R einem Kondensator C und einer Spule L besteht. Der Schwingkreis wird durch einen Generator oder Oszillator 1 mit einer Erregerfrequenz $f_E$ zu einer Schwingung angeregt.

Durch eine solche Schwingung wird ein magnetisches Wechselfeld zum Aussenden von Energie oder Daten erzeugt. Überdies kann ein solcher Schwingkreis auch durch ein externes, magnetisches Wechselfeld zum Schwingen angeregt werden, wodurch Energie oder Daten von außen empfangen werden.

Jeder Schwingkreis besitzt eine Eigenfrequenz oder auch Resonanzfrequenz $f_R$ genannt, die durch die Induktivität der Spule L und die Kapazität des Kondensators der verwendeten Bauelemente des Schwingkreises (Gesamtimpedanz) bestimmt wird:

$$f_R = \sqrt{\frac{1}{LC}}$$

Bei einem Serien- oder Parallelschwingkreis wird die Resonanzfrequenz $f_R$ im wesentlichen durch die Induktivität der Spule L und durch die Kapazität des Kondensators C bestimmt. Der Widerstand R hat im wesentlichen keinen Einfluß auf die Resonanzfrequenz $f_R$. Aus diesem Grund wird der Widerstand R bei der folgenden Betrachtung vernachlässigt.

Zum Aussenden von Energie oder Daten wird der Schwingkreis durch den Oszillator 1 mit einer Erregergröße zu einer Schwingung mit der Erregerfrequenz $f_E$ gezwungen. Als Erregergröße kann die Ausgangsspannung u oder der Ausgangsstrom i des Oszillators 1 verwendet werden. Zwischen dem Oszillator 1 und dem Schwingkreis kann zusätzlich noch ein (nicht dargestellter) Frequenzteiler angeordnet sein, der die Oszillatorfrequenz auf die gewünschte Erregerfrequenz $f_E$ herunterteilt.

Die erzeugte Schwingungsintensität (Amplitude) des auszusendenden oder des empfangenen Signals ist bekanntermaßen am größten, wenn der Schwingkreis mit der Erregerfrequenz $f_E$ gleich der Resonanzfrequenz $f_R$ erregt wird. Dies gilt sowohl für das Senden als auch das Empfangen von Energie oder Daten. Wenn die Erregerfrequenz $f_E$ der empfangenen Schwingung von der Resonanzfrequenz $f_R$ des Schwingkreises abweicht, so wird die empfangene Intensität kleiner.

Infolge von Bauteiletoleranzen, Alterung von Bauteilen oder Temperatureinflüssen kann sich die Resonanzfrequenz $f_R$ des Schwingkreises gegenüber der gewünschten Resonanzfrequenz $f_R$ verschieben. Optimale Bedingungen zum Übertragen und Empfangen von Daten oder Energie werden dann erzielt, wenn die Resonanzfrequenz $f_R$ in etwa mit der Erregerfrequenz $f_E$ übereinstimmt. Hierzu wird erfindungsgemäß vorgesehen, die Impedanz des Schwingkreises durch kontinuierliches Hinzuschalten einer Abgleichimpedanz $Z_{AR}$ so zu verändern, daß die Resonanzfrequenz $f_R$ an die Erregerfrequenz $f_E$ angepaßt wird.

Hierzu wird die Verstimmung, das heißt der Differenz zwischen der Erregerfrequenz $f_E$ und der Resonanzfrequenz $f_R$, gemessen und abhängig davon wird die Abgleichimpedanz $Z_{AR}$ über eine Steuervorrichtung 2 und einen Schalter 3 dem Schwingkreis in bestimmten Zeitintervallen, d.h. nur phasenweise, effektiv hinzu- oder weggeschaltet. Die effektive Größe der so gesteuerten Abgleichimpedanz $Z_{AR}$ ist dabei stufenlos veränderlich und derart bestimmt, daß sich eine neue Resonanzfrequenz $f_R$ ergibt, die an die Erregerfrequenz $f_E$ angepaßt ist. Der Schwingkreis kann mit Hilfe der Steuervorrichtung 2 auch auf einen fest vorgegebenen Verstimmungsgrad eingeregelt werden.

In den Figuren 2a bis 2d sind verschiedene Variationsmöglichkeiten dargestellt, wie die Gesamtimpedanz des Schwingkreises die Abgleichimpedanz $Z_{AR}$ verändert werden kann. So kann eine Abgleichpule $L_{AR}$ in Serie (Figur 2a) oder parallel (Figur 2b) zu der Spule L angeordnet sein. Ebenso kann ein Abgleichkondensator $C_{AR}$ in Serie (Figur 2c) oder parallel (Figur 2d) zu dem Kondensator C des Schwingkreises angeordnet sein.

Beispielsweise kann bei dem Ausführungsbeispiel nach Figur 2d eine effektive Kapazität $C_{AReff}$ des Abgleichkondensators $C_{AR}$, die infolge einer nur phasenweise Ansteuerung des Abgleichkondensators $C_{AR}$ erzielt wird, mit Hilfe der Fourier-Analyse des durch den Abgleichkondensator $C_{AR}$ fließenden Stroms einfach ermittelt werden. Die resultierende Gesamtkapazität $C_{Res}$, die die Resonanzfrequenz $f_R$ bestimmt, errechnet sich in diesem Fall zu:

$$C_{Res} = C_{AReff} + C$$

Bei diesen Variationsmöglichkeiten (Figuren 2a bis 2d) sind jedoch Zusatzschaltelemente unberücksichtigt, die beispielsweise zum Schalten einer Induktivität oder Kapazität notwendig sind. Solche Zusatzschaltelemente sind z.B. Freilaufdioden. Für die Erfindung sind diese Zusatzschaltelemente jedoch unwesentlich.

Im folgenden wird die Erfindung anhand eines Ausführungsbeispiels näher erläutert, bei dem ein Abgleichkondensator $C_{AR}$ - wie in Figur 2d dargestellt - als Abgleichimpedanz $Z_{AR}$ parallel zu dem Kondensator C des Schwingkreises angeordnet ist.

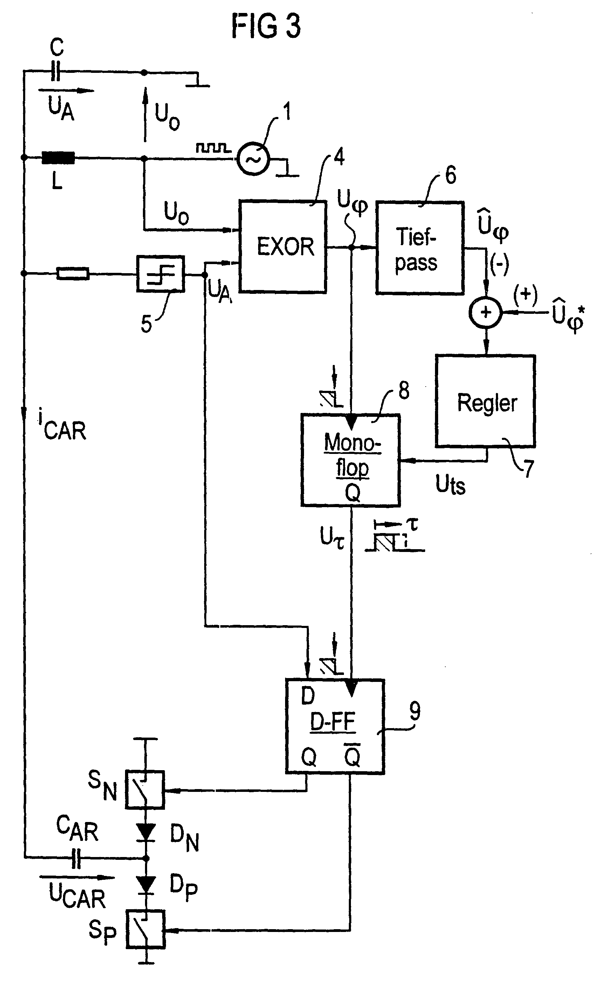

In der Figur 3 ist Ausführungsbeispiel einer Schaltungsanordnung dargestellt, mit der die Abgleichimpedanz $Z_{AR}$ zeitlich gesteuert dem Schwingkreis stufenlos hinzu- oder weggeschaltet werden kann. Der Schwingkreis, der im wesentlichen aus der Spule L und dem Kondensator C besteht, wird von dem Oszillator 1 mit der Erregerfrequenz $f_E$ zum Schwingen angeregt. Der Oszillator 1 erzeugt dabei eine Rechteckschwingung mit der festen Erregerfrequenz $f_E$.

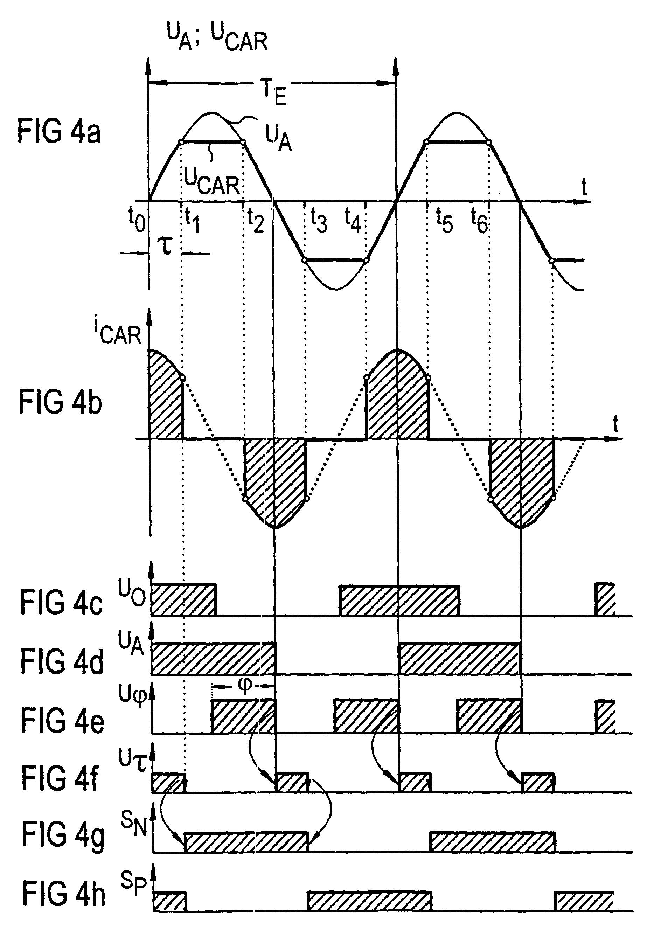

Abhängig von den Bauelementen, d.h. der Spule L und dem Kondensator C, sowie der Güte des Schwingkreises stellt sich zwischen der Spule L und dem Kondensator C eine Schwingkreisspannung $U_A$ (vgl. auch Figur 4a) mit einer bestimmten Schwingungsamplitude und einer Phase in Bezug zu der Phase der Oszillatorspannung $U_O$ ein. Die Amplitude und die Phase der Schwingkreisspannung $U_A$ hängen dabei von der Verstimmung des Schwingkreises, d.h. von der Differenz zwischen der Erregerfrequenz $f_E$ und der Resonanzfrequenz $f_R$ ab.

Wenn die Resonanzfrequenz $f_R$ gleich der Erregerfrequenz $f_E$ (im folgenden als Resonanzfall bezeichnet) ist, dann ist die Phase der Schwingkreisspannung $U_A$ aufgrund der Phasenverschiebung durch die Spule L um 90° nacheilend gegenüber der Phase der Oszillatorspannung $U_O$. Dies ist unabhängig von der Güte des Schwingkreises.

Die Oszillatorspannung $U_O$ wird direkt am Oszillator 1 abgegriffen und als Referenzwert einem EX-OR-Gatter 4 zugeführt (vgl. Figur 4c). Ebenso wird die Schwingkreisspannung $U_A$ zwischen der Spule L und dem Kondensator C abgegriffen, über einen Schmitt-Trigger 5 digitalisiert und ebenfalls dem EXOR-Gatter 4 zugeführt(vgl. Figur 4d). Somit werden die Phase der Oszillatorspannung $U_O$ mit der Phase der Schwingkreisspannung $U_A$ miteinander verglichen, um ihre Phasendifferenz und der daraus sich ergebenden Differenz zwischen der Resonanzfrequenz $f_R$ und der Erregerfrequenz $f_E$ festzustellen.

Am Ausgang des EXOR-Gatters 4 steht ein Phasensignal $U_\varphi$ (vgl. Figur 4e) mit einer Phase $\varphi$ und einer Amplitude $\hat{U}_\varphi$ (Gleichspannungsanteil nach einem Tiefpaß 6) zur Verfügung. Das Phasensignal $U_\varphi$ ist abhängig von der Phasenverschiebung $\varphi$ zwischen der Schwingkreisspannung $U_A$ und Oszillatorspannung $U_O$. Das Phasensignal $U_\varphi$ weist eine Frequenz f auf, die der doppelten Erregerfrequenz $f_E$ ($f = 2f_E$) entspricht.

Der gemessene Gleichspannungsanteil $\hat{U}_\varphi$ und ein vorgegebenes Sollwertsignal $\hat{U}_{\varphi*}$ (Referenzwert), das einer Gleichspannung entspricht, wobei deren Amplitude der Amplitude $\hat{U}_\varphi$ im Resonanzfall entspricht, werden einem Regler 7 zugeführt. Der Regler 7 erzeugt an seinem Ausgang ein Regelsignal $U_{ts}$ und steuert mit diesem Signal ein flankengetriggertes Monoflop 8, durch das ein Steuersignal $U_\tau$ (vgl. Figur 4f) mit Steuerimpulsen der Zeitdauer $\tau$ festgelegt werden.

Das Monoflop 8 wird mit jeder fallenden Flanke des Phasensignals $U_\varphi$, das heißt bei jedem Nulldurchgang der Schwingkreisspannung $U_A$ (vgl. Figur 4a) gestartet. Am Ausgang des Monoflops 8 steht ein Steuersignal $U_\tau$ an, durch das ein D-Flipflop 9 durch seine fallende Flanke getaktet wird. Am D-Eingang des D-Flipflops 9 liegt die digitalisierte Schwingkreisspannung $U_A$ an, durch die - zum Zeitpunkt einer fallenden Flanke des Steuersignals $U_\tau$ - die Zustände der Ausgänge Q und Q des D-Flipflops 9 bestimmt werden (vgl. Figuren 4g und 4h).

Die Ausgänge Q und $\overline{Q}$ des D-Flipflops 9 sind mit Schalter $S_N$ und $S_P$ verbunden, durch die der Abgleichkondensator $C_{AR}$ über Dioden $D_N$ und $D_P$ gegen Masse und infolgedessen zu dem Schwingkreis hinzu- oder weggeschaltet wird.

Anhand der Figuren 4a bis 4h wird im folgenden das erfindungsgemäße Verfahren näher erläutert. Dabei sind in der Figur 4a die Schwingkreisspannung $U_A$ (dünne Kurve in der Figur 4a) und die Abgleichspannung $u_{CAR}$ (fette Kurve in der Figur 4a), die über dem Abgleichkondensator $C_{AR}$ anliegt, dargestellt. Den Verlauf des Ladestroms $i_{CAR}$, der in den Abgleichkondensator $C_{AR}$ fließt und ihn somit auflädt, zeigt Figur 4b. Die Oszillatorspannung $U_O$ und die digitalisierte Schwingkreisspannung $U_A$ sind in den Figuren 4c bzw. 4d gezeigt. Das Phasensignal $U_\varphi$ ist in der Figur 4e und das Steuersignal $U_\tau$ ist in der Figur 4f dargestellt. Die Figuren 4g und 4h zeigen Steuerimpulse für die Schalter $S_N$ bzw. $S_P$.

Zum Zeitpunkt t0 sei der Schalter $S_P$ geschlossen. Der Abgleichkondensator $C_{AR}$ ist somit dem Kondensator C des Schwingkreises parallel zugeschaltet. Die Spannung $U_{ACR}$ an dem Abgleichkondensator $C_{AR}$ folgt der Schwingkreisspannung $U_A$ bis zum Zeitpunkt $t_1$ (dies entspricht der Zeitdauer $\tau$; vgl. Figuren 4a und 4f). Der Abgleichkondensator $C_{AR}$ ist nun auf die Spannung $\hat{U}_A \cdot \sin(2\pi f_E \cdot \tau)$ aufgeladen. Durch Umschalten der Schalter $S_N$ und $S_P$ ($S_N$ wird leitend und $S_P$ wird offen) nach der Zeitdauer $\tau$ (zum Zeitpunkt $t_1$) wird ein weiteres Aufladen des Abgleichkondensators $C_{AR}$ unterbunden, da die Diode $D_N$ sperrt, wenn die Schwingkreisspannung $U_A$ größer ist als die Abgleichspannung $u_{CAR}$. Und da die Ladung des Abgleichkondensators $C_{AR}$ dann konstant bleibt, erhöht sich das Spannungspotential im Knotenpunkt, wenn die Schwingkreisspannung $U_A$ weiter ansteigt.

Da der Schalter $S_N$ leitend geschaltet ist, kann zum Zeitpunkt $t_2$ (Figur 4a) ein negativer Ladestrom $i_{CAR}$ über die Diode $D_N$ und den Schalter $S_N$ einsetzen, sobald die Schwingkreisspannung $U_A$ die Abgleichspannung $u_{CAR}$ unterschreitet. Denn dann liegt der Knotenpunkt zwischen den beiden Schaltern $S_N$ und $S_P$ wieder auf Masse. Der negative Ladestrom $i_{CAR}$ wird zum Zeitpunkt $t_3$ durch erneutes Umschalten nach der Zeitdauer $\tau$ nach dem Nulldurchgang der Schwingkreisspannung $U_A$ (Ausschalten des Schalters $S_N$) unterbrochen und kann zum Zeitpunkt $t_4$ wieder in positiver Richtung über die Diode $D_P$ und den Schalter $S_P$ einsetzen.

Zum Zeitpunkt $t_5$ wird der Ladevorgang erneut unterbrochen (Einschalten des Schalters $S_N$ und Ausschalten des Schalters $S_P$). Somit ergeben sich für den Ladestrom $i_{CAR}$, der den Abgleichkondensator $C_{AR}$ auflädt, beidseitig angeschnittene Cosinusverläufe (vgl. Figur 4b, fett dargestellte Kurve), so daß der Abgleichkondensator $C_{AR}$ nur teilweise wirksam dem Schwingkreis zugeschaltet ist (es wirkt nur seine effektive Kapazität $C_{AReff}$).

Die Anschnittbreite wird über die Zeitdauer $\tau$ gesteuert. Je größer die Zeitdauer $\tau$ wird, desto länger fließt der Ladestrom $i_{CAR}$. Je kürzer die Zeitdauer $\tau$ wird, desto weniger Ladestrom $i_{CAR}$ (d.h. kleinere Ladung des Abgleichkondensators $C_{AR}$) fließt durch den Abgleichkondensator $C_{AR}$. Da der Ladestrom $i_{CAR}$ durch die Kapazität des Abgleichkondensators $C_{AR}$ und die zeitliche Ableitung der Abgleichspannung $u_{CAR}$ definiert ist ($i_{CAR} = C_{AR} \cdot du_{CAR}/dt$), ergibt sich aus der Umkehrung davon, daß die Ladung und somit wirksame Kapazität $C_{AReff}$ des Abgleichkondensators $C_{AR}$ durch den zeitabhängigen Ladestrom $i_{CAR}$, und damit durch die Zeitdauer $\tau$ bestimmt wird.

Da die Zeitdauer $\tau$ abhängig von der Differenz der Erregerfrequenz $f_E$ und der Resonanzfrequenz $f_R$ ist, wird der Schwingkreis infolgedessen durch die Erfindung stufenlos und automatisch abgeglichen. Es kann also über die Zeitdauer $\tau$ die Wirksamkeit des Abgleichkondensators $C_{AR}$ und somit die Resonanzfrequenz $f_R$ stetig gesteuert werden. Daher ist bei Zuschalten des Abgleichkondensators $C_{AR}$ nicht sein voller Kapazitätswert wirksam, sondern nur ein dem Ladestrom $i_{CAR}$ entsprechender Teil davon, wodurch die effektive Kapazität $C_{AReff}$ bewirkt wird.

Wenn die Zeitdauer $\tau$ größer wird, so liegen die Zeitpunkte $t_1$ und $t_2$ sowie $t_5$ und $t_6$ nahe beieinander, während gleichzeitig der Zeitraum zwischen den Zeitpunkten $t_0$ und $t_1$ bzw. $t_4$ und $t_5$ größer wird. Umgekehrt wird der Zeitraum zwischen den Zeitpunkten $t_0$ und $t_1$ kleiner, wenn die Zeitdauer $\tau$ kleiner werden soll.

Es sei nun angenommen, daß der Schwingkreis nach unten verstimmt ist, d. h. die Summe aus der Kapazität des Kondensators C und dem wirksamen Anteil der Kapazität des Abgleichkondensators $C_{AR}$ sei zu groß. Dies hat zur Folge, daß die Schwingkreisspannung $U_A$ gegenüber der Oszillatorspannung $U_O$ um mehr als 90° in der Phase nacheilt. Das sich am Ausgang des EXOR-Gatters 4 ergebende Phasensignal $U_\varphi$ hat ein Impuls-Pausenverhältnis von größer als 50%. Der Gleichspannungsanteil $\hat{U}_\varphi$ ist somit größer als der Referenzwert $\hat{U}_{\varphi^*}$. Der Regler 7 erhält eine negative Regelabweichung und steuert seine Regelsignal $U_{ts}$ zurück. Die daraus resultierende Zeitdauer T wird auf diese Weise geringer und der wirksame Anteil des Abgleichkondensators $C_{AR}$ mit Hilfe des Ladestroms $i_{CAR}$ so weit reduziert, bis die Resonanzfrequenz $f_R$ erreicht ist.

Der Abgleichkondensator $C_{AR}$ wird also dadurch dem Schwingkreis hinzugeschaltet, daß der Abgleichkondensator $C_{AR}$ durch den Ladestrom $i_{CAR}$ phasenanschnittgesteuert geladen wird. Dies bedeutet, daß der Ladestrom $i_{CAR}$ nicht während der gesamten Periodendauer $T_E$ der Schwingung wirksam fließt, sondern nur während einiger von der Zeitdauer $\tau$ abhängigen Phasenabschnitte. Der Abgleichkondensator $C_{AR}$ wird also nicht vollständig geladen, so daß nur ein Teil seiner Kapazität wirksam wird und auf den Schwingkreis einwirkt. Wenn ein Abgleichkondensator $C_{AR}$ mit einem höheren Gesamtwert eingesetzt wird, so ist folglich der wirksame Anteil und auch der Regelbereich größer. Wird nur ein kleiner Abgleichkondensator $C_{AR}$ verwendet, so kann nur in einem kleinen Kapazitätsbereich die Gesamtkapazität des Schwingkreises geändert werden.

Die Verwendung eines Kondensators als Abgleichimpedanz $Z_{AR}$ hat den Vorteil, daß ein kostengünstiges Bauelement als Abgleichelement für den Schwingkreis dient. Die Bauelementetoleranzen des Abgleichkondensators $C_{AR}$ haben keinen Einfluß auf die Abstimmung, da diese über die Steuervorrichtung 2 ausgeregelt werden können.

Bei der Dimensionierung des Schwingkreises kann beispielsweise der Kondensator C in seinem Kapazitätswert kleiner dimensioniert werden, so daß auf jeden Fall ein Teil des Abgleichkondensators $C_{AR}$ wirksam zu dem Kondensator C hinzugeschaltet werden muß, damit die Resonanzfrequenz $f_R$ eingeregelt werden kann. Dadurch wird erreicht, daß ein Stellbereich für die Resonanzfrequenz $f_R$ erzielt wird, wie er durch eine Zuschaltung von $\pm$ ½$C_{AR}$ erreicht würde. Daher kann die Gesamtkapazität des Schwingkreises größer und auch kleiner werden.

Die Größe des Abgleichkondensators $C_{AR}$ und des Kondensators C des Schwingkreises wird so bestimmt, daß bei den zu erwartenden Bauteiletoleranzen und Temperatureinflüssen noch ein Abgleich des Schwingkreises sicher möglich ist. So können die Kapazitätswerte für $C_{AR}$ und C so gewählt werden, daß die folgende Bedingung sicher erfüllt ist (ausgehend von einer gewünschten Erregerfrequenz $f_E$ und bei Parallelschaltung des Abgleichkondensators $C_{AR}$) :

$$\sqrt{\frac{1}{L \cdot (C + C_{AR})}} < f_E < \sqrt{\frac{1}{L \cdot C}}$$

Vorteilhaft ist es, diese Vorrichtung bei einer Diebstahlschutzvorrichtung (nicht in der Zeichnung dargestellt) für ein Kraftfahrzeug einzusetzen. Insbesondere kann die erfindungsgemäße Vorrichtung bei einer Wegfahrsperre eingesetzt werden. Hierzu ist ein erster Schwingkreis in einem Schloß (Schloßschwingkreis), vorzugsweise in dem Zündschloß angeordnet und wird von einem Oszillator 1 angesteuert. In einer ersten Phase werden Energiesignale erzeugt, die durch ein magnetisches Wechselfeld über die Spule des Schloßschwingkreises ausgesendet werden.

Ein tragbarer Transponder, der auf einer Chipkarte oder einem Zündschlüssel angeordnet ist, weist ebenfalls einen Schwingkreis (Schlüsselschwingkreis) auf. Wenn die Spule des Schlosses und des Transponder nahe beieinander angeordnet sind, so findet eine transformatorische Übertragung von Energie und Daten statt.

Der Schwingkreis des Schlosses sendet die Energiesignale aus, die den Schlüsselschwingkreis zum Schwingen anregen. Diese Schwingung wird durch eine schlüsselspezifische Codeinformation moduliert. Das somit erzeugte hochfrequente Magnetfeld wirkt auf den Schloßschwingkreis zurück und erregt seinerseits dort eine Schwingung.

Die im Schloßschwingkreis erregte modulierte Schwingung wird von einer Auswerteeinheit erfaßt. Die Codeinformation wird daraus demoduliert, in einem Komparator mit einer Sollcodeinformation verglichen und bei Übereinstimmung wird ein Freigabesignal an die Wegfahrsperre gesendet. Somit weist der Transponder seine Berechtigung zum Starten des Kraftfahrzeugs nach.

Sowohl im Schloßschwingkreis als auch im Schlüsselschwingkreis kann unabhängig voneinander ein erfindungsgemäßer Abgleich der Resonanzfrequenz $f_R$ stattfinden. Wenn die Resonanzfrequenz $f_R$ des Schloßschwingkreises nicht mit der Erregerfrequenz $f_E$ des Oszillators 1 übereinstimmt, so wird die Resonanzfrequenz $f_R$ erfindungsgemäß geändert. Wenn die Resonanzfrequenz $f_R$ des Schlüsselschwingkreises nicht mit der Frequenz der übertragenen Energiesignale übereinstimmt, so wird die Resonanzfrequenz $f_R$ des Schlüsselschwingkreises geändert. Und wenn dann die Resonanzfrequenz $f_R$ des Schloßschwingkreises nicht mit der Frequenz der übertragenen Codesignale übereinstimmt, so kann nochmals die Resonanzfrequenz $f_R$ des Schloßschwingkreises verändert werden.

Hierzu wird dementsprechend der Abgleichkondensator $C_{AR}$ eines jeden Schwingkreises phasenanschnittgesteuert jeweils dem Schwingkreis zugeschaltet. Zuvor wird jedoch die Verstimmung des Schwingkreises über die Phasenverschiebung zwischen der Anregung und der Schwingung erfaßt.

Die erfindungsgemäße Vorrichtung und das Verfahren zum Übertragen von Energie oder Daten kann auch bei weiteren Vorrichtungen verwendet werden, bei denen Schwingkreise zum Übertragen oder Empfangen von Signalen eingesetzt werden.

Die Steuervorrichtung 2 mit dem Regelkreis zum Ändern der Resonanzfrequenz $f_R$ kann dabei sowohl analog als auch digital realisiert werden. Ein Ausführungsbeispiel in Analogtechnik ist in der Figur 3 dargestellt. Ebenso kann der Abgleichkondensator $C_{AR}$ auch digital über einen Mikroprozessor gesteuert hinzu- oder weggeschaltet werden.

Die Steuervorrichtung 2, die aus dem Schmitt-Trigger 5, dem EXOR-Gatter 4, dem Tiefpaß, dem Regler 7, dem Monoflop 8 und dem D-Flipflop 9 besteht, kann auch als integrierter Schaltkreis ausgebildet sein. Ebenso können die Schalter $S_N$ und $S_P$ in Form von Schalttransistoren sowie die Dioden $D_N$ und $D_P$ integriert sein.

Alle Bauelemente müssen dabei eine Spannungsfestigkeit von z.T. mehreren' hundert Volt aufweisen, da die Schwingkreisspannung $U_A$ bei Verwendung in einem Diebstahlschutzsystem eine maximale Amplitude von etwa 100V erreicht.

Mit dieser Vorrichtung kann somit auf einfache Weise die Verstimmung des Schwingkreises gemessen sowie automatisch und stufenlos ausgeregelt werden. Auch ist abhängig von dem Abgleichkondensator $C_{AR}$ ein großer Regelbereich möglich, da Kondensatoren mit sehr hohen Kapazitätswerten einfach und billig hergestellt werden können.

**Patentansprüche**

1. Vorrichtung zum kontaktlosen Übertragen von Energie oder Daten mit einem Schwingkreis (R,L,C), der durch Schwingen ein magnetisches Wechselfeld zum Aussenden von Energie oder Daten erzeugt oder der durch ein externes, magnetisches Wechselfeld zum Schwingen angeregt wird, wodurch Energie oder Daten empfangen werden, und dessen Resonanzfrequenz ($f_R$) durch seine Bauteile (L,C) bestimmt wird, wobei die Resonanzfrequenz ($f_R$) durch Hinzuschalten einer Impedanz ($Z_{AR}$; $C_{AR}$) kontinuierlich verändert und an eine Erregerfrequenz ($f_E$), mit der der Schwingkreis zum Schwingen angeregt wird, angepaßt wird, **dadurch gekennzeichnet,** daß sie eine Zeitsteuereinheit (2; 3 - 9) aufweist, durch die die Impedanz ($Z_{AR}$; $C_{AR}$) abhängig von der Differenz zwischen der Resonanzfrequenz ($f_R$) und der Erregerfrequenz ($f_E$) jeweils innerhalb einer Periodendauer ($T_E$) der Schwingung nur phasenweise dem Schwingkreis hinzugeschaltet wird.

2. Vorrichtung nach Anspruch 1, **dadurch gekennzeichnet**, daß die Impedanz ($Z_{AR}$) ein Kondensator ($C_{AR}$) ist, der parallel oder in Serie zu einem Kondensator (C) des Schwingkreises angeordnet ist.

3. Vorrichtung nach Anspruch 1, **dadurch gekennzeichnet**, daß die Impedanz ($Z_{AR}$) eine Induktivität ($L_{AR}$) ist, die parallel oder in Serie zu einer Spule (L) des Schwingkreises angeordnet ist.

4. Verfahren zum kontaktlosen Übertragen von Energie oder Daten einem Schwingkreis (R,L,C), der durch Schwingen ein magnetisches Wechselfeld zum Aussenden von Energie oder Daten erzeugt oder der durch ein externes, magnetisches Wechselfeld zum Schwingen erregt wird und dessen Resonanzfrequenz ($f_R$) durch seine Bauteile bestimmt wird, wobei die Resonanzfrequenz ($f_R$) durch Hinzuschalten einer Impedanz ($Z_{AR}$) kontinuierlich verändert und an eine Erregerfrequenz $f_E$ angepaßt wird, **dadurch gekennzeichnet**, daß die Impedanz durch eine Zeitsteuereinheit (2) abhängig von der Differenz zwischen der Resonanzfrequenz ($f_R$) und der Erregerfrequenz ($f_E$) jeweils innerhalb einer Periodendauer ($T_E$) der Schwingung nur phasenweise dem Schwingkreis hinzugeschaltet wird, wodurch nur ein Teil der Impedanz ($Z_{AR}$) wirksam wird.

**Claims**

1. Device for contactless transmission of power or data with a resonant circuit (R,L,C) which, as a result of oscillation, generates an alternating magnetic field in order to transmit power or data or which is excited to oscillation by an external alternating magnetic field, as a result of which power or data are received, and the resonant frequency ($f_R$) of which is determined by its components (L,C), the resonant frequency ($f_R$) being continuously altered by switching in an impedance ($Z_{AR}$; $C_{AR}$) and being matched to an excitation frequency ($f_E$) with which the resonant circuit is excited to oscillation, **characterized in that** the said device has a timing control unit (2; 3-9), by means of which the impedance ($Z_{AR}$; $C_{AR}$) is switched into the resonant circuit only in a phasewise manner depending on the difference between the resonant frequency ($f_R$) and the excitation frequency ($f_E$) in each case within a period ($T_E$) of the oscillation.

**2.** Device according to Claim 1, **characterized in that** the impedance ($Z_{AR}$) is a capacitor ($C_{AR}$), which is arranged in parallel or in series with a capacitor (C) of the resonant circuit.

**3.** Device according to Claim 1, **characterized in that** the impedance ($Z_{AR}$) is an inductance ($L_{AR}$), which is arranged in parallel or in series with a coil (L) of the resonant circuit.

**4.** Method for contactless transmission of power or data with a resonant circuit (R,L,C) which, as a result of oscillation, generates an alternating magnetic field in order to transmit power or data or which is excited to oscillation by an external alternating magnetic field, and the resonant frequency ($f_R$) of which is determined by its components, the resonant frequency ($f_R$) being continuously altered by switching in an impedance ($Z_{AR}$) and being matched to an excitation frequency $f_E$ with which the resonant circuit is excited to oscillation, **characterized in that** the impedance is switched, by means of a timing control unit (2) into the resonant circuit only in a phasewise manner depending on the difference between the resonant frequency ($f_R$) and the excitation frequency ($f_E$) in each case within a period ($T_E$) of the oscillation, as a result of which only part of the impedance ($Z_{AR}$) becomes effective.

**Revendications**

**1.** Dispositif pour la transmission sans contact d'énergie ou de données, comportant un circuit (R, L, C) oscillant, qui, par oscillation, produit un champ alternatif magnétique pour l'émission d'énergie ou de données ou qui est mis en oscillation par un champ magnétique alternatif externe, ce qui fait que de l'énergie ou des données sont reçues, et dont la fréquence ($f_R$) de résonance est déterminée par ses composants (L, C), la fréquence ($f_R$) de résonance étant modifiée en continu en raccordant une impédance ($Z_{AR}$ ; $C_{AR}$) et étant accordée à une fréquence ($f_E$) d'excitateur à laquelle le circuit oscillant est mis en oscillation, **caractérisé en ce qu'**il comporte une unité (2 ; 3 à 9) de commande en fonction du temps par laquelle l'impédance ($Z_{AR}$ ; $C_{AR}$) est, en fonction de la différence entre la fréquence ($f_R$) de résonance et la fréquence ($f_E$) d'excitateur chaque fois en l'espace d'une période ($T_E$) de l'oscillation, raccordée seulement par phase au circuit oscillant.

**2.** Dispositif suivant la revendication 1, **caractérisé en ce que** l'impédance ($Z_{AR}$) d'un condensateur ($C_{AR}$) est montée en parallèle ou en série avec un condensateur (C) du circuit oscillant.

**3.** Dispositif suivant la revendication 1, **caractérisé en ce que** l'impédance ($Z_{AR}$) est une inductance ($L_{AR}$) qui est montée en parallèle ou en série avec une bobine (L) du circuit oscillant.

**4.** Procédé pour la transmission sans contact d'énergie ou de données par un circuit (R, L, C) oscillant, qui, par oscillation, produit un champ alternatif magnétique pour l'émission d'énergie ou de données ou qui est mis en oscillation par un champ magnétique alternatif externe, ce qui fait que de l'énergie ou des données sont reçues, et dont la fréquence ($f_R$) de résonance est déterminée par ses composants (L, C), la fréquence ($f_R$) de résonance étant modifiée en continu en raccordant une impédance ($Z_{AR}$ ; $C_{AR}$) et étant accordée à une fréquence ($f_E$) d'excitateur à laquelle le circuit oscillant est mis en oscillation, **caractérisé en ce que** l'impédance est raccordée par une unité (2) de commande en fonction du temps, en fonction de la différence entre la fréquence ($f_R$) de résonance et la fréquence $f_E$ d'excitateur chaque fois pendant une période ($T_E$) de l'oscillation, seulement par phases au circuit oscillant, ce qui fait que seulement une partie de l'impédance ($Z_{AR}$) est active.

## FIG 1

## FIG 2a

## FIG 2b

## FIG 2c

## FIG 2d

# FIG 3

FIG 4a

FIG 4b

FIG 4c

FIG 4d

FIG 4e

FIG 4f

FIG 4g

FIG 4h